# EUROPEAN PATENT APPLICATION

(11) **EP 3 499 519 A1**
(43) Date of publication of application: **19.06.2019**
(21) Application number: 17839240.3
(22) Date of filing: 27.07.2017
(51) Int. Cl.: H01B 12/06, C01G 1/00, C01G 3/00, H01F 6/06, H01L 39/00, H01L 39/24, C23C 28/00

(54) **OXIDE SUPERCONDUCTING WIRE**

(30) Priority: 09.08.2016 JP 2016156430
(71) Applicant: Fujikura Ltd., Tokyo 135-8512 (JP)
(72) Inventor: OHSUGI, Masaki, Sakura-shi Chiba 285-8550 (JP)
(74) Representative: Cabinet Plasseraud
(86) International application number: PCT/JP2017/027249
(87) International publication number: WO 2018/030167

(57) **Abstract**

Provided is an oxide superconducting wire including a superconducting laminate including a tape-shaped substrate, an intermediate layer provided on one face of the substrate, an oxide superconducting layer provided on the intermediate layer, and a protective layer covering a surface of the oxide superconducting layer, in which two of the superconducting laminates are disposed to be superposed on each other in a thickness direction, and the two superconducting laminates are integrated by a metal layer which is provided at least on both lateral faces of the two superconducting laminates in a width direction, such that the two superconducting laminates form a non-fixed portion therebetween which is not fixed in a longitudinal direction of the superconducting laminate.

## Description

### TECHNICAL FIELD

The present invention relates to an oxide superconducting wire.

Priority is claimed on Japanese Patent Application No. 2016-156430, filed on August 9, 2016, the content of which is incorporated herein by reference.

### BACKGROUND ART

An RE-Ba-Cu-O based superconductor (here, RE represents a rare earth element) represented by a general formula such as REBa₂Cu₃O_{X} (RE123) shows superconductivity at a temperature (to 90 K) exceeding a liquid nitrogen temperature (77 K). Since this oxide superconductor has a higher critical current density in a magnetic field than other high temperature superconductors, applications to coils, power cables, and the like are expected. A superconducting wire using this oxide superconductor is manufactured by forming an intermediate layer on a substrate, forming an oxide superconducting layer on a surface thereof, and further forming a protective layer of Ag, Cu, or the like on a surface thereof (see, for example, Patent Document 1).

### PRIOR ART DOCUMENTS

### PATENT DOCUMENTS

[Patent Document 1] Japanese Unexamined Patent Application, First Publication No. 2015-146318

### SUMMARY OF THE INVENTION

### PROBLEMS TO BE SOLVED BY THE INVENTION

In a case of using an oxide superconducting wire as a coil by impregnating it with a resin, there is a possibility of peeling stress acting to deteriorate the wire, due to a thermal shrinkage difference between the wire and the resin when it is cooled to a temperature exhibiting superconductivity, or hoop stress during conducting.

The present invention has been made in view of the above circumstances, and an object thereof is to provide an oxide superconducting wire capable of preventing an oxide superconducting layer and the like from peeling, even if a force such as heat shrinkage acts on a superconducting wire as a structure in which the superconducting wire is processed as a superconducting coil and is solidified with an impregnating resin.

### MEANS FOR SOLVING THE PROBLEMS

In order to solve the problems, according to an aspect of the present invention, an oxide superconducting wire includes a superconducting laminate including a tape-shaped substrate, an intermediate layer provided on one face of the substrate, an oxide superconducting layer provided on the intermediate layer, and a protective layer covering a surface of the oxide superconducting layer, in which two of the superconducting laminates are disposed to be superposed on each other in a thickness direction, and the two superconducting laminates are integrated by a metal layer which is provided at least on both lateral faces of the two superconducting laminates in a width direction, such that the two superconducting laminates form a non-fixed portion therebetween which is not fixed in a longitudinal direction of the superconducting laminate.

The superconducting laminate may include a stabilizing layer using plating.

The metal layer may be a tape-shaped metal foil, and the metal foil and the superconducting laminate may be bonded with a bonding material therebetween.

The metal foil may be a metal foil having higher strength than a copper foil.

The non-fixed portion may include a non-adhesive layer that is non-adhesive with respect to the bonding material.

The metal layer may be formed using plating.

The non-fixed portion may include a non-adhesive layer that is non-adhesive with respect to the plating when forming the metal layer.

The non-adhesive layer may be a tape having no adhesion strength at a temperature lower than a temperature at which the non-adhesive layer has adhesion strength.

The non-adhesive layer may be formed of an oxide film.

The non-adhesive layer may be formed of a silicone resin or a fluororesin.

### Effects of Invention

According to the aspect of the present invention, it is possible to prevent an oxide superconducting layer and the like from peeling, even if stress such as heat shrinkage acts on a superconducting wire as a structure in which the superconducting wire is processed as a superconducting coil and is solidified with an impregnating resin.

### BRIEF DESCRIPTION OF THE DRAWINGS

FIG. 1 is a cross-sectional view illustrating an oxide superconducting wire according to a first embodiment.
FIG. 2 is a cross-sectional view illustrating an oxide superconducting wire according to a second embodiment.
FIG. 3 is a cross-sectional view illustrating an oxide superconducting wire according to a third embodiment.
FIG. 4 is a cross-sectional view illustrating an oxide superconducting wire according to a fourth embodiment.

### EMBODIMENTS FOR CARRYING OUT THE INVENTION

Hereinafter, the present invention will be described based on a preferred embodiment with reference to the drawings.

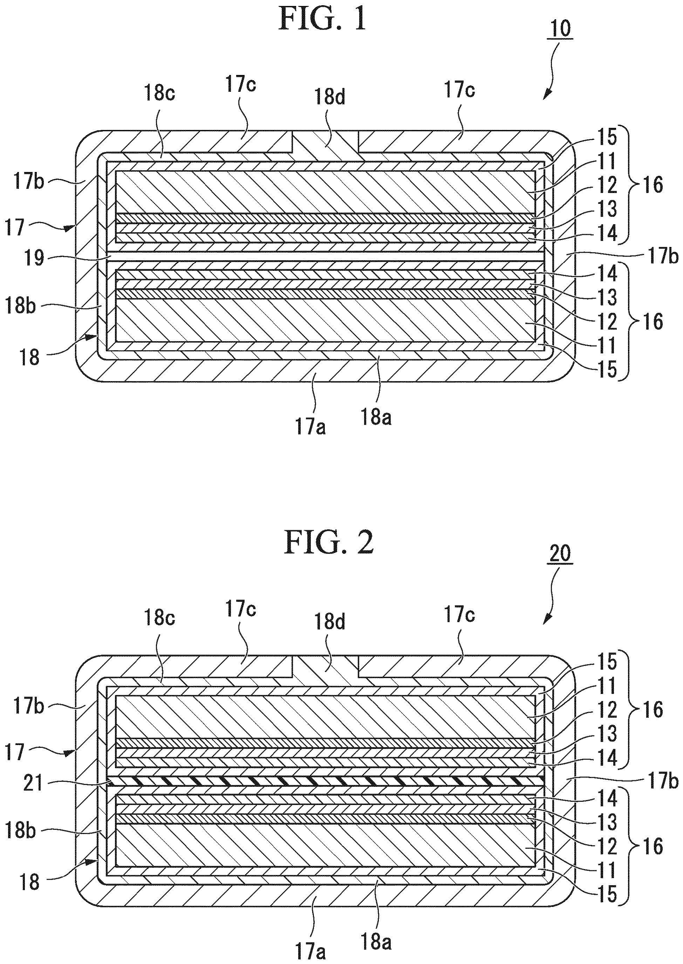

FIG. 1 shows a cross-sectional view of an oxide superconducting wire according to a first embodiment. The cross-sectional view shown in FIG. 1 schematically shows a structure of a cross section perpendicular to a longitudinal direction of an oxide superconducting wire 10. The oxide superconducting wire 10 includes two superconducting laminates 16 and 16, a metal foil 17 provided on the periphery of the superconducting laminates 16 and 16, and a bonding material 18 bonding the metal foil 17 to the periphery of the superconducting laminates 16 and 16.

The superconducting laminate 16 has a configuration in which a tape-shaped substrate 11, and an intermediate layer 12, an oxide superconducting layer 13, and a protective layer 14 which are laminated in that order on one face (first face) of the substrate 11.

In other words, the superconducting laminate 16 includes the tape-shaped substrate 11, the intermediate layer 12 provided on one face of the substrate 11, the oxide superconducting layer 13 provided on the intermediate layer 12, and the protective layer 14 covering a surface of the oxide superconducting layer 13.

In addition, the superconducting laminate 16 may further have a stabilizing layer 15 using plating.

In the present specification, a direction in which the layers such as the substrate 11, the intermediate layer 12, the oxide superconducting layer 13, and the protective layer 14 are laminated is a thickness direction (a thickness direction of the oxide superconducting wire and a thickness direction of the superconducting laminate). In addition, a width direction (a width direction of the oxide superconducting wire and a width direction of the superconducting laminate) is a direction perpendicular to a longitudinal direction and the thickness direction (of the oxide superconducting wire and the superconducting laminate). A lateral face of the superconducting laminate is each lateral face (one lateral face or both lateral faces) on both sides in the width direction.

The substrate 11 is a tape-shaped metal substrate and has main faces (one face and a back face opposite the one face) on both sides in the thickness direction. Specific examples of the metal forming the substrate 11 include a nickel alloy represented by Hastelloy (registered trademark), stainless steel, and an oriented Ni-W alloy obtained by introducing a texture to a nickel alloy. A thickness of the substrate 11 may be appropriately adjusted according to a purpose, for example, in a range of 10 to 500 µm. In order to improve the bonding property with respect to the bonding material 18, a metal thin film of Ag, Cu, or the like may be further formed on the back face, the lateral face, or both the back face and the lateral face of the substrate 11. In addition, this metal thin film (second protective layer) may be integrated with the protective layer 14 formed on the surface of the oxide superconducting layer 13.

The intermediate layer 12 is provided between the substrate 11 and the oxide superconducting layer 13. The intermediate layer 12 may have a multilayer structure. For example, as the intermediate layer 12, a diffusion prevention layer, a bed layer, a textured layer, a cap layer, and the like may be laminated on the substrate 11 in order from the substrate 11 to the oxide superconducting layer 13. Each of the layers forming the intermediate layer 12 is not necessarily provided one by one, and there may be a case where some layers are omitted, or a case where two or more layers having the same type are repeatedly laminated.

The diffusion prevention layer has a function of preventing a part of a component of the substrate 11 from diffusing and mixing into the oxide superconducting layer 13 as impurities. The diffusion prevention layer is formed of, for example, Si₃N₄, Al₂O₃, and GZO (Gd₂Zr₂O₇). A thickness of the diffusion prevention layer is, for example, 10 to 400 nm.

On the diffusion prevention layer, the bed layer may be formed in order to reduce a reaction at an interface between the substrate 11 and the oxide superconducting layer 13 and improve the orientation of the layers formed thereon. Examples of a material of the bed layer include Y₂O₃, Er₂O₃, CeO₂, Dy₂O₃, Eu₂O₃, Ho₂O₃, and La₂O₃. A thickness of the bed layer is, for example, 10 to 100 nm.

The textured layer is formed of a biaxially textured material in order to control a crystal orientation of the cap layer on the textured layer. Examples of the material of the textured layer can include metal oxides such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, and Nd₂O₃. The textured layer is preferably formed by an ion-beam-assisted deposition (IBAD) method.

The cap layer is formed on a surface of the textured layer described above and is formed of a material which enables grains to show self-epitaxy in an in-plane direction. Examples of the material of the cap layer include CeO₂, Y₂O₃, Al₂O₃, Gd₂O₃, ZrO₂, YSZ, Ho₂O₃, Nd₂O₃, and LaMnO₃. A thickness of the cap layer is, for example, in a range of 50 to 5000 nm.

The oxide superconducting layer 13 is formed of an oxide superconductor. The oxide superconductor is not particularly limited, but examples thereof include an RE-Ba-Cu-O based oxide superconductor represented by a general formula of REBa₂Cu₃O_{X} (RE123). Examples of the rare earth element RE include one or two or more of Y, La, Ce, Pr, Nd, Sm, Eu, Gd, Tb, Dy, Ho, Er, Tm, Yb, and Lu. Among these, one of Y, Gd, Eu, and Sm or a combination of two or more of these elements is preferable. In general, X is 7-x (oxygen deficiency amount x: approximately 0 to 1). A thickness of the superconducting layer is, for example, approximately 0.5 to 5 µm. The thickness of the superconducting layer is preferably uniform in the longitudinal direction.

The protective layer 14 has a function of bypassing an overcurrent generated at the time of a problem or suppressing a chemical reaction occurring between the oxide superconducting layer 13 and a layer provided on the protective layer 14.

Examples of a material of the protective layer 14 include silver (Ag), copper (Cu), gold (Au), an alloy of gold and silver, other silver alloys, a copper alloy, and a gold alloy. The protective layer 14 covers at least the surface of the oxide superconducting layer 13 (a face on a side opposite a substrate 11 side in the thickness direction). Further, the protective layer 14 may cover a part or the entirety of a region selected from the lateral face of the oxide superconducting layer 13, the lateral face of the intermediate layer 12, and the lateral face and the rear surface of the substrate 11. The protective layer 14 may be formed of two or more types of metal layers. The protective layer 14 may be formed of two or more metal layers. The thickness of the protective layer 14 is, for example, approximately 1 to 30 µm, and in a case where the protective layer 14 is thinned, the thickness thereof may also be 10 µm or less.

The stabilizing layer 15 using plating (plating stabilizing layer) can be formed as metal plating (not shown) of Cu, Ag, Al, or the like, for example, on the lateral face of the superconducting laminate 16 or on the outer peripheral surface such as on the protective layer 14. Instead of the plating stabilizing layer, or in combination with the plating stabilizing layer, metal foil, metal tape, or the like may be laminated on the periphery of the superconducting laminate 16 as the stabilizing layer 15 (the stabilizing layer 15 may be configured to cover the outer periphery of the superconducting laminate 16). In this case, it is possible to perform bonding to the substrate 11, the oxide superconducting layer 13, the protective layer 14, and the like by providing a bonding material (not shown) such as solder on an inner face of the stabilizing layer 15.

The stabilizing layer 15 is formed such that a single layer of the stabilizing layer 15 corresponds to only the one superconducting laminate 16, without spanning the two superconducting laminates 16 and 16 (without forming a single layer of the stabilizing layer 15 to tie the superconducting laminates 16 and 16). As a material of the stabilizing layer 15, a material having low electric resistance is preferable so as to function as a shunt circuit, and a material having high thermal conductivity is more preferable so as to ensure heat exchange with the refrigerant. A thickness of the stabilizing layer 15 is, for example, approximately 15 to 300 µm.

In the present embodiment, two superconducting laminates 16 and 16 are superposed in the thickness direction, and a gap portion 19 is provided between the superconducting laminates 16 and 16. The gap portion 19 forms a non-fixed portion which is not fixed in the longitudinal direction of the superconducting laminates 16 and 16. The non-fixed portion is not limited to a non-contact portion, and surfaces of the two superconducting laminates 16 and 16 may be partially or entirely in contact with each other via the gap portion 19.

In addition, the metal foil 17 is provided to cover at least both sides in the width direction of the two superconducting laminates 16 and 16 (both lateral faces of the two superconducting laminates 16 and 16). The metal foil 17 and the superconducting laminates 16 and 16 are bonded with the bonding material 18 therebetween. The metal foil 17 is bonded to two superconducting laminates 16 and 16 so as to span both sides of the gap portion 19. In other words, the metal foil 17 is bonded to the two superconducting laminates 16 and 16 such that the gap portion 19 is provided between the two superconducting laminates 16 and 16 (such that the two superconducting laminates 16 and 16 are disposed apart from each other). Accordingly, the two superconducting laminates 16 and 16 are integrated as one oxide superconducting wire 10.

That is, in the present embodiment, the two superconducting laminates 16 and 16 are disposed to be superposed on each other in the thickness direction of the oxide superconducting wire 10, and the two superconducting laminates are integrated by a metal layer which is provided at least on both lateral faces of the two superconducting laminates in the width direction, such that the two superconducting laminates 16 and 16 form a non-fixed portion therebetween which is not fixed in a longitudinal direction of the superconducting laminates 16 and 16.

Examples of a method of forming the superconducting laminates 16 and 16 to be non-fixed therebetween include a method in which, when performing the bonding with the bonding material 18, facing faces are not wetted with the bonding material 18 by providing a face (non-coated face) which is not coated with a flux on one or both of the faces (two facing faces) on which the superconducting laminates 16 and 16 face each other. Examples of the flux include a resin based flux, an inorganic based flux, an organic based flux, a water soluble flux, and a solvent based flux, and generally include an activator such as acids and salts. For example, in a case of a liquid flux in which the metal surface is activated at the time of coating and a function of the activator is deactivated due to drying or the like, even when a flux coated face is in contact with a non-coated face, the non-coated face is not easily activated by the flux. Also in a case of coating the metal foil 17 with the flux, the entire inner face of metal foil 17 may be coated with the flux.

In this manner, the non-fixed portion is included between the superconducting laminates 16 and 16 and at least both lateral face portions in the width direction of the superconducting laminates 16 and 16 are covered with the metal foil 17. Accordingly, even when an external force acts on the metal foil 17, an inner portion of the superconducting laminate 16 (in particular, the oxide superconducting layer 13 and an interface between the oxide superconducting layer 13 and a layer on the periphery of the oxide superconducting layer 13) does not receive the external force. Therefore, the oxide superconducting layer 13 does not easily peel off and becomes the oxide superconducting wire 10 having high strength. When the metal foil 17 is bonded to three faces that are both lateral faces of the superconducting laminate 16 and the back face of the superconducting laminate 16 on which the substrate 11 is provided, it is possible to improve sealability against moisture, which is preferable.

Next, as an example of another form of the non-fixed portion, FIG. 2 shows a cross-sectional view of an oxide superconducting wire according to a second embodiment. An oxide superconducting wire 20 is formed in the same manner as that of the first embodiment, except that the non-fixed portion is formed of a non-adhesive layer 21.

The non-adhesive layer 21 can be formed by interposing a material (non-adhesive material) having a non-adhesive property with respect to the bonding material 18, between the superconducting laminates 16 and 16. The non-adhesive layer 21 may be laminated on one or both of the facing faces (two facing faces) at which the superconducting laminates 16 and 16 face each other. In addition, the flux non-coated face according to the first embodiment can be used in combination with the non-adhesive layer 21.

For example, it is possible to provide the non-adhesive layer 21 on a surface (first facing face) of one (first) superconducting laminate 16 and provide the flux non-coated face on a surface (second facing face) of the other (second) superconducting laminate 16.

Examples of the non-adhesive material forming the non-adhesive layer 21 include an oxide film, a silicone resin, and a fluororesin such as Teflon (registered trademark). In a case where the oxide film is selected as the non-adhesive material, it is also possible to form the oxide film by oxidizing the metal at a surface portion of the superconducting laminate 16, and it is possible to form a film of a metal oxide such as alumina from the outside. In a case where the resin such as a silicone resin or a fluororesin is used as the non-adhesive material, the resin can be selected from various states such as a liquid state, a gel state, a sol state, and a solid state to be used. In addition, as the non-adhesive material, it is also possible to use a tape having adhesion strength at a temperature at which the bonding material 18 becomes a liquid and having no adhesion strength at a temperature at which the bonding material 18 becomes a solid, for example, a temperature sensitive sticking agent and an adhesive.

Next, in common with the first and second embodiments, steps of bonding the metal foil 17 to the periphery of the superconducting laminates 16 and 16 will be described.

The metal foil 17 is tape-shaped (metal tape) and extends in the longitudinal direction of the oxide superconducting wires 10 and 20. The metal foil 17 has a cross-sectional shape bent in the width direction from one face of one superconducting laminate 16 at the periphery of the superconducting laminates 16 and 16 (The metal foil 17 has a cross-sectional shape bent from the back face of the substrate 11 provided on one superconducting laminate 16 so as to cover the lateral face of the superconducting laminate 16). Accordingly, since the lateral face of the oxide superconducting layer 13 can be stably covered, the water resistance of the oxide superconducting wires 10 and 20 can be improved.

In the case of the present embodiment, the metal foil 17 completely covers the one face of the first superconducting laminate 16, and includes a connecting portion 17a that connects lateral face portions 17b and 17b on both sides, the lateral face portions 17b and 17b that respectively cover both lateral faces of the superconducting laminates 16 and 16, and bent end portions 17c and 17c folded back along the one face of the second superconducting laminate 16. One or both of the bent end portions 17c and 17c may be omitted and the end portion in the width direction of the metal foil 17 may be provided on the lateral face portion 17b.

In an unfolded state of the metal foil 17, the lateral face portion 17b and the bent end portion 17c can be provided on both sides in the width direction of the connecting portion 17a, in that order. The bent end portions 17c and 17c are preferably formed of both end portions of the metal foil 17 so as to cover both end portions in the width direction of the second superconducting laminate 16. The connecting portion 17a and the bent end portion 17c are preferably substantially flat. For example, the connecting portion 17a and the bent end portion 17c may be parallel to each other. A thickness of the metal foil 17 is, for example, approximately 15 to 300 µm.

A material used for the metal foil 17 may vary depending on the application of the oxide superconducting wires 10 and 20. For example, in a case in which it is used for a superconducting cable, a superconducting motor, or the like, it is necessary that it function as a main part of a bypass that commutates an overcurrent generated at the transition to a normal conducting state. Therefore, a metal with good conductivity is suitably used. Examples of the metal with good conductivity include metals such as copper, a copper alloy, aluminum, and an aluminum alloy. In this case, the metal foil 17 also functions as a stabilizing layer.

In addition, in a case of using the oxide superconducting wires 10 and 20 for a superconducting fault current limiter, it is necessary to instantaneously suppress the overcurrent generated at the transition to the normal conducting state. Therefore, a high resistance metal is suitably used for the metal foil 17. Examples of a high resistance metal include a Ni based alloy such as Ni-Cr. In addition, in order to further improve peeling strength of the superconducting laminate 16, it is possible to use a metal tape such as SUS having higher strength than a Cu foil or the like, as the metal foil 17.

Examples of a bonding material forming the bonding material 18 include Sn-Pb based, Pb-Sn-Sb based, Sn-Pb-Bi based, Bi-Sn based, Sn-Cu based, Sn-Pb-Cu based, or Sn-Ag based solder, or the like, Sn, an Sn alloy, In, an In alloy, Zn, a Zn alloy, Ga, and a Ga alloy. A melting point of the bonding material is, for example, 500 °C or lower and further 300 °C or lower. A thickness of the bonding material 18 is, for example, 1 to 10 µm.

Examples of a method of providing the metal foil 17 and the bonding material 18 on the periphery of the superconducting laminates 16 and 16 include a method including a step of disposing the metal foil 17 on the periphery of the first superconducting laminate 16, a step of bending the metal foil 17 along an external form of the superconducting laminates 16 and 16 (forming), a step of heating and pressing the superconducting laminates 16 and 16 and the metal foil 17 to melt a part or all of the bonding material 18 (re-melting or re-flowing), and a step of solidifying the bonding material by cooling it in its entirety while continuing the pressing.

Specific examples of the forming include a step in which the superconducting laminates 16 and 16 are disposed on the flat metal foil 17, both end portions in the width direction of the metal foil 17 are then bent toward the lateral faces of the superconducting laminates 16 and 16, and both end portions in the width direction of the metal foil 17 are further bent along the second superconducting laminate 16. According to the forming, it is possible to efficiently produce a product having the same cross sectional shape continuous in the longitudinal direction of the superconducting wire.

The distribution of the bonding material 18 to the inner surface of the metal foil 17 is not particularly limited, but it is preferable to consider a bonding property to the superconducting laminate 16, prevention of moisture penetration, electrical conductivity through the bonding material 18, and the like. For example, the bonding material 18 may have a bonding material 18a bonding the connecting portion 17a of the metal foil 17 and the superconducting laminate 16. In addition, the bonding material 18 may have a bonding material 18b bonding the lateral face portion 17b of the metal foil 17 and the superconducting laminate 16. In addition, the bonding material 18 may also have a bonding material 18c bonding the bent end portion 17c of the metal foil 17 and the superconducting laminate 16. A space of the metal foil 17 and the superconducting laminate 16 may be completely filled with the bonding material 18 and may have an area in which the bonding material 18 is not formed on a portion thereof.

A thickness of the bonding material 18b used for the lateral face portion 17b can be made larger than the thickness of the bonding materials 18a and 18c used for the connecting portion 17a or the bent end portion 17c. For example, the thickness of the bonding material 18b of the lateral face portion is preferably, for example, 5% or more, 10% or more, 20% or more of the width of the superconducting laminate 16, or 50% or more, 100% or more, twice or more of the thickness of the superconducting laminate 16, or 100 µm or more, 200 µm or more, or 500 µm or more.

In a case of manufacturing the oxide superconducting wires 10 and 20 having a large thickness of the bonding material 18b on the lateral face portion, when performing the step of bending the metal foil 17 (forming), it is preferable to perform a forming process by, for example, bringing a jig into contact with the outer face side of the metal foil 17 or the like such that a distance between the lateral face of the superconducting laminate 16 and the metal foil 17 increases.

When the thickness of the bonding material 18b covering the lateral face of the superconducting laminate 16 is increased, when the lateral face of the superconducting laminate 16 has unevenness, the bonding material 18b can easily adhere thereto. In addition, since the bonding material 18b is a layer formed of a single material over the entire thickness of the superconducting laminate 16 and does not have a weak interface on the inner portion, it is possible to enhance the strength of the end portion in the width direction of the oxide superconducting wires 10 and 20. In addition, a starting point of delamination of the superconducting laminate 16 is not easily generated, and it is possible to improve the peeling strength. For example, when a strong external force acts on the superconducting wire due to an electromagnetic force during conducting, thermal shrinkage of an insulating material (a resin) or the like on the periphery of the wire, residual stress, or the like, even in a case where stress concentrates at the end portion of the width direction than in the center portion, peeling between the layers forming the superconducting wire can be suppressed.

A supplying method of the bonding material 18 is not particularly limited. The bonding material 18 may be attached to one or both of the superconducting laminates 16 and 16 and the metal foil 17 in advance. Alternatively, a liquid or solid bonding material may be supplied between the superconducting laminates 16 and 16 and the metal foil 17. It is possible to use two or more types of supplying methods in combination. Examples of the method of attaching the bonding material 18 to the superconducting laminates 16 and 16 or the metal foil 17 include a method of sputtering the bonding material, a method of plating the bonding material (such as electroplating), a method of using a molten bonding material (such as hot-dipping), and a combination of two or more of these.

The width of the metal foil 17 in a deployed state is preferably shorter than the circumference surrounding all of the two superconducting laminates 16 and 16. Accordingly, when the metal foil 17 is formed so as to surround the outer periphery of the superconducting laminate 16, end portions in the width direction of the metal foil 17 do not overlap each other. Therefore, the end portion of the metal foil 17 does not easily float from the superconducting laminate 16. It is preferable to seal a gap formed between the end portions in the width direction of the metal foil 17 by providing a closing portion 18d using solder, welding, or the like.

The closing portion 18d may be formed of the bonding material with which a gap portion is formed between both end portions in the width direction of the metal foil 17. The bonding material with which the closing portion 18d is filled can be formed after bonding the superconducting laminates 16 and 16 and the metal foil 17. In addition to this, the closing portion 18d can be formed by a welding portion. The welding portion may include some of the materials diffused from members of the periphery during welding, for example, some of the materials of the substrate 11, the protective layer 14, the stabilizing layer 15, the metal foil 17, the bonding material 18, and the like. When forming the welding portion, a material such as a metal may be further supplied from the outside. The outer face of the closing portion 18d may protrude or recess from the outer face of the metal foil 17 or may be flush with the outer face of the metal foil 17.

In the first and second embodiments, the two superconducting laminates 16 and 16 are disposed such that the oxide superconducting layers 13 and 13 are provided between the substrates 11 and 11. The current flowing through the oxide superconducting wires 10 and 20 may flow over the plurality of oxide superconducting layers 13 and 13. Accordingly, it is possible to increase a current-carrying amount of the oxide superconducting wire.

In contrast to the first and second embodiments, one or both of the oxide superconducting layers 13 and 13 may be disposed on an outside of the respective substrates 11 and 11.

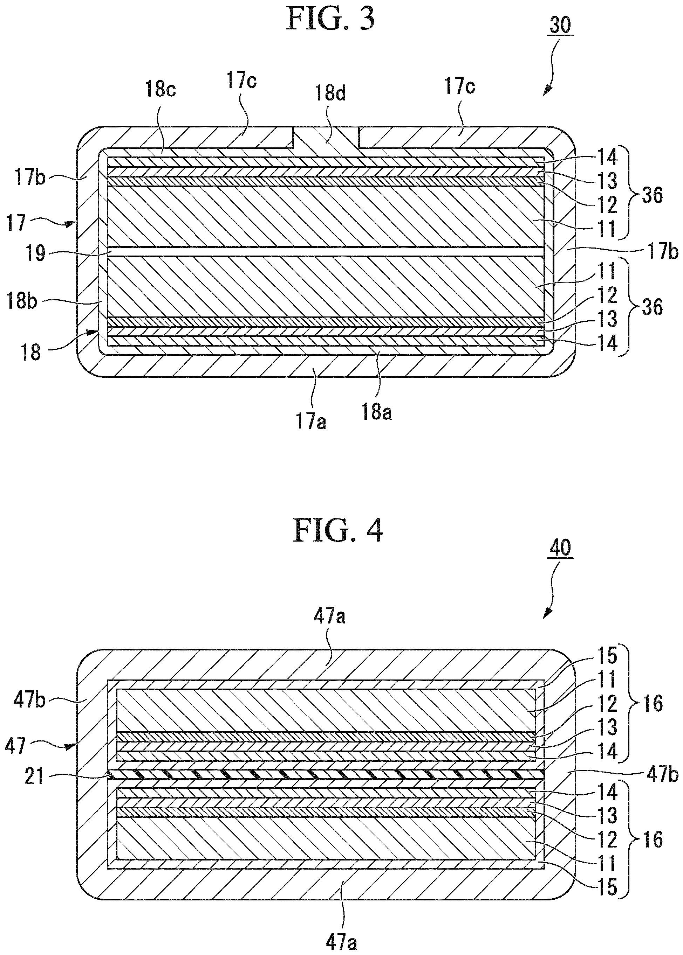

FIG. 3 shows a cross-sectional view of an oxide superconducting wire according to a third embodiment. In an oxide superconducting wire 30 according to the third embodiment, both of the oxide superconducting layers 13 and 13 are disposed on the outside of the substrates 11 and 11. The current flowing through the oxide superconducting wire 30 may flow over the plurality of oxide superconducting layers 13 and 13 via the metal foil 17 or the like. Accordingly, it is possible to increase the current-carrying amount of the oxide superconducting wire. In this case, since the substrate 11 is not interposed between the oxide superconducting layer 13 and the metal foil 17 and an area where the metal foil 17 is bonded to the oxide superconducting layer 13 via the protective layer 14 or the bonding material 18 is wide, it is possible to make the metal foil 17 function better as the stabilizing layer.

In the present embodiment, FIG. 3 shows a case of a superconducting laminate 36 that includes the substrate 11, the intermediate layer 12, the oxide superconducting layer 13, and the protective layer 14, but does not include a stabilizing layer 15 (see FIGS. 1 and 2). A method of manufacturing the oxide superconducting wire 30 is the same as that of the first embodiment and the second embodiment.

In any of the embodiments, the superconducting laminates 16 and 36 optionally have the stabilizing layer 15.

The metal layer integrating the plurality of superconducting laminates is not limited to the metal foil, and for example, may be a metal layer such as a plated layer. The metal layer integrating the plurality of superconducting laminates is a metal layer disposed to span the plurality of superconducting laminates, and hereinafter will be referred to as an "integrating metal layer".

Examples of a general method of manufacturing an oxide superconducting wire include a manufacturing method including a step of manufacturing a superconducting laminate which may or may not have a stabilizing layer, a step of superposing the superconducting laminate in a thickness direction, and a step of integrating the superconducting laminates so as not to be fixed therebetween, by forming an integrated metal layer at least on both sides (both lateral faces) in a width direction of the superconducting laminate.

The integrating metal layer is preferably formed continuously in the longitudinal direction of the superconducting laminate so as to cover at least the non-fixed portion between the superconducting laminates. In addition, in order to protect the oxide superconducting layer from moisture, air, or the like, it is preferable that both end portions (both lateral faces) in the width direction of the oxide superconducting layer be covered with the integrating metal layer. In order for the integrating metal layer to function also as the stabilizing layer, it is preferable to form the integrating metal layer using Cu, Ag, Al, or the like having excellent electrical conductivity and excellent thermal conductivity.

Next, as an example of another form of the integrating metal layer, FIG. 4 shows a cross-sectional view of an oxide superconducting wire according to a fourth embodiment. An oxide superconducting wire 40 according to the fourth embodiment is formed in the same manner as in the second embodiment, except that a plated layer 47 is formed as an integrating metal layer on the periphery of the two superconducting laminates 16 and 16. An aspect of a non-fixed layer in the present embodiment is not limited to the same one as the non-adhesive layer 21 according to the second embodiment, and can be configured similarly to the gap portion 19 according to the first embodiment.

In a case where a plated layer 47 is used as the integrating metal layer, in a plating step, it is possible to narrow the gap between the superconducting laminates 16 and 16 such that the plating is not formed between the superconducting laminates 16 and 16 superimposed in the thickness direction or laminate the non-adhesive layer 21 using the non-adhesive material to the plating. The non-adhesive layer 21 may be laminated on one or both of the facing faces (two facing faces) at which the superconducting laminates 16 and 16 face each other, and may be sandwiched without being fixed to both of the superconducting laminates 16 and 16.

In addition, in the plating step, it is possible to maintain an integrated state without a gap between the superconducting laminates 16 and 16 or between the superconducting laminates 16 and 16 and the non-adhesive layer 21, by pressing faces (non-facing faces) opposite the faces at which the two superconducting laminates 16 and 16 face each other with a roller or the like.

The stabilizing layer 15 of the superconducting laminate 16 can be omitted. However, it is preferable to form an underlayer of metal or the like on the outer face of the superconducting laminate 16 such that the plated layer 47 easily adheres to the back face or lateral face of the substrate 11. In a case where the stabilizing layer 15 of Cu or the like is provided on the periphery of the superconducting laminate 16, the adhesion with the plated layer 47 of Cu or the like is excellent, which is preferable. A thickness of the plated layer 47 is, for example, approximately 15 to 300 µm.

Examples of the non-adhesive material to the plating include an oxide film, a silicone resin, and a fluororesin such as Teflon (registered trademark). In a case where the oxide film is used as the non-adhesive material, it is also possible to form the oxide film by oxidizing the metal at a surface portion of the superconducting laminate, and it is possible to form a film of a metal oxide such as alumina from the outside. In a case where the resin such as a silicone resin or a fluororesin is used as the non-adhesive material, the resin can be selected from various states such as a liquid state, a gel state, a sol state, and a solid state to be used.

In addition, as the non-adhesive material, it is also possible to use a tape having adhesion strength at a temperature (for example, a normal temperature or a high temperature) at the time of a plating step and having no adhesion at a temperature (for example, a low temperature or a normal temperature) after the plating step, for example, a temperature sensitive sticking agent and an adhesive. Accordingly, when forming the plated layer 47, the plating does not adhere to the surface of the superconducting laminate 16, and it is possible to prevent the superconducting laminates 16 and 16 from being fixed to each other. The plating step may be carried out at room temperature or at a high temperature.

In a case where the tape having no adhesion at a temperature lower than the temperature at which adhesion is exhibited is used as the non-adhesive material, a tape having no adhesion at the low temperature (for example, liquid nitrogen temperature) at which the oxide superconducting wire is used may be used. In this case, the tape may have adhesion at the normal temperature (for example, around 20 to 30 °C). Here, the adhesion strength of the tape means an adhesion strength (adhesive force) capable of fixing the superconducting laminates 16 and 16 therebetween.

In addition, the non-adhesive layer 21 may be interleaving paper having no adhesion or having weak adhesion. The interleaving paper may be a sheet or a film of a resin or the like having heat resistance.

When compared to a case where the metal foil 17 is the integrating metal layer (for example, see FIG. 2), in a case where the plated layer 47 is the integrating metal layer, the bonding material 18 can be omitted. In addition, it is also possible to form a circumferentially continuous plated layer 47 in, for example, the entire circumference of the two superconducting laminates 16 and 16 without forming the closing portion 18d in the gap at the end portion in the width direction of the metal foil 17. In the case of FIG. 4, the plated layer 47 includes connecting portions 47a and 47a connecting the lateral face portions 47b and 47b on both sides and lateral face portions 47b and 47b respectively covering both lateral faces of the superconducting laminates 16 and 16. The connecting portion 47a may be laminated on the surface (non-facing face) of one or both of the superconducting laminates 16.

As the integrating metal layer, it is possible to use two or more types of metal layers in combination. For example, an integrating metal layer covering one side (first lateral face) in the width direction of the superconducting laminate and an integrating metal layer covering the other side (second lateral face) may be separated as separate metal layers. Materials of the separate metal layers may be the same as or different from each other.

The integrating metal layer may cover a part or the entire face (non-facing face) opposite the faces at which the two superconducting laminates face each other. One or both of the non-facing faces may not be covered by the integrating metal layer.

In order to prepare a superconducting coil using a tape-shaped oxide superconducting wire, a superconducting wire is wound around a required number of layers along the outer peripheral surface of a bobbin to form a coil shape (multilayer wound coil), and then the wound superconducting wire is impregnated with a resin such as an epoxy resin so as to cover the superconducting wire, and the superconducting wire can be fixed.

Hereinbefore, the present invention has been described based on the preferred embodiments. However, the present invention is not limited to the embodiments described above, and approximate modifications can be made in a range not departing from the present invention.

For example, it is possible to omit, combine, or modify one or two or more of the configurations included in the first to fourth embodiments.

The oxide superconducting wire can include an external terminal. In a portion having the external terminal, a sectional structure different from other portions may be provided.

The non-fixed portion may not be fixed at least at a low temperature (for example, liquid nitrogen temperature) at which an oxide superconducting wire is used by superconductivity, and may not be fixed or may be fixed at a normal temperature (for example, around 20 to 30 °C).

### [Examples]

Hereinafter, the present invention will be described using examples. The present invention is not limited to only the examples.

### <Example 1>

(1) A surface of a substrate (12 mm in width × 1000 mm in length × 0.75 mm in thickness) of Hastelloy (registered trademark) C-276 (trade name of Haynes International, Inc.) was polished.
(2) The surface of the substrate was degreased and cleaned with acetone.
(3) A 100 nm diffusion prevention layer of Al₂O₃ was formed on the substrate by ion beam sputtering.
(4) A 30 nm bed layer of Y₂O₃ was formed on the diffusion prevention layer by ion beam sputtering.
(5) A 5 to 10 nm textured layer of MgO was formed on the bed layer by an ion beam assisted deposition method.
(6) A 500 nm cap layer of CeO₂ was formed on the textured layer by a pulsed laser deposition method.
(7) A 2 µm oxide superconducting layer of GdBa₂Cu₃O₇₋ₓ was formed on the cap layer by the pulsed laser deposition method.
(8) A 2 µm protective layer of Ag was formed on the oxide superconducting layer by sputtering from the direction of the surface of the oxide superconducting layer.
(9) The superconducting laminate was subjected to oxygen annealing.
(10) The superconducting laminate was slit processed to 4 mm in width.
(11) A1 µm film of Cu was formed on a front face and a back face of the superconducting laminate by sputtering.
(12) A 20 µm stabilizing layer (optional) of Cu was formed on the entire circumference of the superconducting laminate by plating.
(13) Soldering was performed on the periphery of the two superconducting laminates superposed in a thickness direction by using an oxygen-free copper foil having a thickness of 20 µm to obtain an oxide superconducting wire. At the time of bonding, flux was not applied to faces at which the two superconducting laminates faced each other (for example, the facing face on an oxide superconducting layer side), such that solder did not adhere. The solder used for the bonding is not limited to an alloy, and may be Sn. In addition, a material to which the solder does not adhere may be laminated on the facing face.

### <Example 2>

(1) In the same manner as in (1) to (12) of Example 1, a superconducting laminate having a stabilizing layer of Cu on the outer periphery was prepared.
(2) Interleaving paper was placed between the two superconducting laminates, and a plating process was carried out on the periphery of the superconducting laminates superposed in the thickness direction (lateral face and non-facing face) to obtain an oxide superconducting wire. The interleaving paper preferably has no adhesion or has weak adhesion.

According to these examples, in the oxide superconducting wire, the two superconducting laminates are not fixed therebetween. Therefore, it is possible to suppress the delamination of the superconducting laminate.

### DESCRIPTION OF REFERENCE NUMERAL

- 10, 20, 30, 40: Oxide superconducting wire
- 11: Substrate
- 12: Intermediate layer
- 13: Oxide superconducting layer
- 14: Protective layer
- 15: Stabilizing layer
- 16, 36: Superconducting laminate
- 17: Metal layer (metal foil)
- 18: Bonding material
- 19: Non-fixed portion (gap portion)
- 21: Non-fixed portion (non-adhesive layer)
- 47: Metal layer (plated layer)

## Claims

1. An oxide superconducting wire comprising:
a superconducting laminate including a tape-shaped substrate, an intermediate layer provided on one face of the substrate, an oxide superconducting layer provided on the intermediate layer, and a protective layer covering a surface of the oxide superconducting layer,
wherein two of the superconducting laminates are disposed to be superposed on each other in a thickness direction, and
the two superconducting laminates are integrated by a metal layer which is provided at least on both lateral faces of the two superconducting laminates in a width direction, such that the two superconducting laminates form a non-fixed portion therebetween which is not fixed in a longitudinal direction of the superconducting laminate.

2. The oxide superconducting wire according to claim 1,
wherein the superconducting laminate includes a stabilizing layer using plating.

3. The oxide superconducting wire according to claim 1 or 2,
wherein the metal layer is a tape-shaped metal foil, and
the metal foil and the superconducting laminate are bonded with a bonding material therebetween.

4. The oxide superconducting wire according to claim 3,
wherein the metal foil is a metal foil having a higher strength than a copper foil.

5. The oxide superconducting wire according to claim 3 or 4,
wherein the non-fixed portion includes a non-adhesive layer that is non-adhesive with respect to the bonding material.

6. The oxide superconducting wire according to claim 1 or 2,
wherein the metal layer is formed using plating.

7. The oxide superconducting wire according to claim 6,
wherein the non-fixed portion includes a non-adhesive layer that is non-adhesive with respect to the plating when forming the metal layer.

8. The oxide superconducting wire according to claim 5 or 7,
wherein the non-adhesive layer is a tape having no adhesion strength at a temperature lower than a temperature at which the non-adhesive layer has adhesion strength.

9. The oxide superconducting wire according to claim 5 or 7,
wherein the non-adhesive layer is formed of an oxide film.

10. The oxide superconducting wire according to claim 5 or 7,
wherein the non-adhesive layer is formed of a silicone resin or a fluororesin.
